# EUROPEAN PATENT APPLICATION

(11) **EP 1 496 077 A1**
(43) Date of publication of application: **12.01.2005**
(21) Application number: 03745885.8
(22) Date of filing: 02.04.2003
(51) Int. Cl.: C08G 65/26, C08G 65/332, C08F 290/14, C08F 299/02, G03F 7/027, G03F 7/038

(54) **NOVEL POLYETHER COMPOUND CONTAINING ACID GROUP AND UNSATURATED GROUP, PROCESS FOR PRODUCING THE SAME, AND RESIN COMPOSITION**

(30) Priority: 04.04.2002 JP 2002103070
(71) Applicant: DAICEL CHEMICAL INDUSTRIES, Ltd., Sakai-shi, Osaka 590-0905 (JP)
(72) Inventor: OKAZAKI, Akira, Otake-shi, Hiroshima 739-0651 (JP); MIYAKE, Hiroto, Otake-shi, Hiroshima 739-0651 (JP)
(74) Representative: Grünecker, Kinkeldey, Stockmair & Schwanhäusser Anwaltssozietät
(86) International application number: PCT/JP2003/004195
(87) International publication number: WO 2003/085028

(57) **Abstract**

The present invention relates to a cyclohexyl ring-containing polyether compound which has, in a molecule, two or more polymeri zable unsaturated groups typified by (meth)acryloyloxy groups and one or more acid groups typified by carboxyl groups. The polyether compound provides: a resin composition which has high developability with a dilute alkali and sensitivity and is suitable for use in image formation, e.g., for forming a solder resist or pigment-dispersed resist for a printed circuit board, etc.; and a cured article obtained by curing the resin composition.

## Description

### Technical Field

The present invention relates to a polyether compound containing two or more polymerizable unsaturated groups and an acid group, a resin composition and an image-forming material each containing the polyether compound, a cured article obtained by curing the resin composition, and a process for producing the polyether compound.

A multifunctional polyether compound having polymerizable unsaturated groups according to the present invention is applicable to many fields including: the field of various kinds of coating such as ink, plastic coating, paper printing, film coating, metal coating, and paint application on furniture; lining; an adhesive; and the filed of electronics such as insulating varnish, pigment-dispersed resist, an insulating sheet, a laminated plate, and a material for encapsulating semiconductors. In addition, the polyether compound of the present invention contains an acid group, so that the polyether compound will be suitable in image-forming applications such as solder resist on a printed circuit board and pigment-dispersed resin because of its high developability with diluted alkali and high sensitivity.

### Background Art

Active energy ray curable resin compositions, which can be cured by irradiation with an active energy ray such as an ultraviolet ray or an electron beam, have been developed and practically used in various applications related to printing, coating, and electric insulation.

The advantages of the active energy ray curable compositions include (1) low environmental pollution because they are free of solvents, (2) high product productivity because of their extremely high curing speed, (3) extremely small change in volume before or after curing because they are cured as solid ingredients, and (4) no heat loss from raw materials or no influence on raw materials. Therefore, various compositions have been also developed for coatings, adhesives, and liquid-resist inks for plastic, paper, inorganic materials, and so on. However, the conventional liquid-resist ink contains an organic solvent as a developer, and thus the problem of air pollution remains unresolved. In addition, the solvent is expensive while the solvent resistance and acid resistance of the ink are instable.

Furthermore, JP 57-164595 A and so on have disclosed methods in which an aqueous alkali solution is used instead of an organic solvent as a developer.

The active energy ray curable resins generally used in coatings, inks, and adhesives include an epoxy(meth)acrylate resin prepared by conducting a ring-opening reaction on the epoxy group of an epoxy resin with acrylic acid or methacrylic acid as described in JP 06-157965 A. However, the epoxy(meth)acrylate resin has disadvantages in that it is hard, brittle, and inflexible and is shrunk extensively when it is cured. For example, if the epoxy (meth) acrylate resin is used for an ink for paper printing, a problem will arise such that an inked portion suffers cracks when the surface of the paper is bent after printing.

If epoxy (meth) acrylate resin is used for coating on a metal such as iron or aluminum, a coating layer breaks when the coated metal plate is bent. Thus, it may be impossible to process the metal or the adhesiveness of the resin may be poor even though the coating is applied on the metal such as iron or aluminum. In addition, for adding (meth)acrylic acid to epoxy groups through a ring-opening reaction in a sufficient manner and preventing an increase in acid value, there is a need of reacting the epoxy groups with carboxyl groups at an equivalent ratio. In order not to leave a free acid ingredient as it is, an increase in reaction temperature, an extension in aging time, or an increase in the amount of a reaction catalyst fed should be executed. Therefore, there are problems of a decrease in production efficiency and an increase in discoloration of a reaction solution.

For solving the problems, the effectiveness of an acrylate compound of the formula (3) described in JP 04-164921 A and JP 04-258617 A has been recognized. However, the acrylate compound of the formula (3) has no carboxyl groups on its resin skeleton and no alkali-developability, so that the compound will require the use of an organic solvent as a developer.

The present invention aims to provide a compound with improved alkali-developability and sensitivity, a production process of the compound, a resin composition using the compound, and a cured article of the resin composition.

### Disclosure of the Invention

In consideration of the above circumstances, as a result of investigation eagerly made on the development of a curable compound that provides an excellent active energy ray curable composition and a cured article, the inventors of the present invention have found a polyether compound having two or more polymerizable unsaturated groups and an acid group of the present invention. The inventors have also found that a novel polyether compound capable of providing a cured article having high developability and high photosensitivity can be produced by the use of a curable composition characterized by containing the polyether compound, resulting in completion of the present invention.

According to a first aspect of the present invention, there is provided a polyether compound represented by the following formula (4) having two or more polymerizable unsaturated groups and one or more acid groups in a molecule. 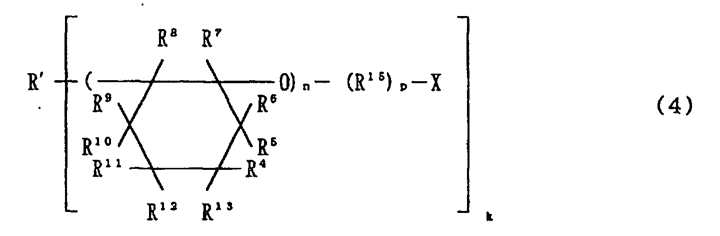 [In the formula (4):
R' is a residue -RHₘ₋ₖ of an organic compound RHₘ containing **m** pieces of active hydrogen in a molecule or a group derived from the residue (where **m** is an integer of 1 to 30 and **k** is 1 to **m**);
R⁴ to R¹³ are each a hydrogen atom, a C₁-C₁₀ hydrocarbon group, or a C₁-C₁₀ hydrocarbon group having a polymerizable unsaturated group (where the polymerizable unsaturated group contains -OCO-CR³=CR¹R², R¹ and R² are hydrogen atoms, R³ is a hydrogen atom or a C₁-C₁₀ hydrocarbon group, and another group may be placed between the hydrocarbon group and -OCO-CR³=CR¹R²), and at least one of R⁴ to R¹³ is a C₁-C₁₀ hydrocarbon group having the polymerizable unsaturated group;
R¹⁵ is a residue of a polybasic acid anhydride;
**x** is -COOH, -PO(OH)ₐ(OR)_{b}, or -SO₃R (where R is a hydrogen, a methyl group, or an ethyl group, **a** is 1 or 0, and **a** + **b** = 2);
**n** is an integer of 1 or more, and the total of **n** in a molecule is 2 to 50; and
P is an integer of 0 when **x** is -PO(OH)ₐ(OR)_{b} or -SO₃R and 1 or more when **x** is -COOH]

According to a second aspect of the present invention, there is provided a polyether compound according to the first aspect of the present invention, in which the polymerizable unsaturated group is a (meth)acryloyloxy group.

According to a third aspect of the present invention, there is provided a polyether compound according to the first aspect of the present invention, in which the acid group is a carboxyl group.

According to a fourth aspect of the present invention, there is provided a polyether compound according to the first aspect of the present invention, represented by the following formula (4A) having two or more (meth) acryloyloxy groups and one or more carboxyl groups in a molecule. 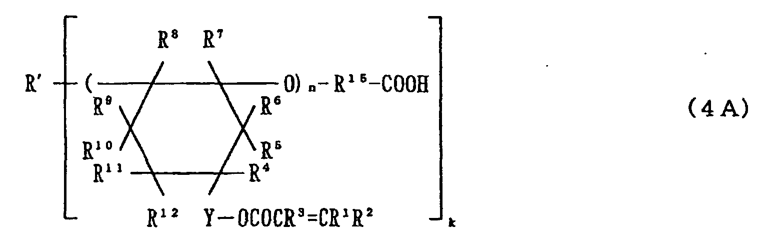 [In the formula (4A):
R' is a residue -RHₘ₋ₖ of an organic compound RHₘ containing **m** active hydrogens in a molecule or a group derived from the residue (where **m** is an integer of 1 to 30 and **k** is 1 to **m**);
R⁴ to R¹² are each a hydrogen atom or a C₁-C₁₀ hydrocarbon groups;
- OCO-CR³=CR¹R² is a (meth)acryloyloxy group;
Y is one of the following structural formulas

   - (CH₂)ₙ₁-,

   -(CH₂)ₙ₁-(OCO(CH₂)₄)ₙ₂-,

   -(CH₂)ₙ₁-(OCO(CH₂)₅)ₙ₂-,

   and

   -(CH₂)ₙ₁-(OCOCH₂-CH(CH₃)-(CH₂)₂)ₙ₂-

   (where **n1** is 1 to 6, hydrogen may be partially substituted with a methyl group, an ethyl group, or a propyl group, and **n2** is 1 to 10);
R¹⁵ is a residue caused by ring-opening of a polybasic acid anhydride; and
**n** is an integer of 1 or more, and the total of **n** in a molecule is 2 to 50]

According to a fifth aspect of the present invention, there is provided a polyether compound according to any one of the first to fourth aspects of the present invention, in which the polybasic acid anhydride is at least one selected from the group consisting of tetrahydrophthalic anhydride, 4-methyl tetrahydrophthalic anhydride, 3-methyl tetrahydrophthalic anhydride, 3,4,5,6-tetrahydrophthalic anhydride, and hexahydrophthalic anhydride.

According to a sixth aspect of the present invention, there is provided a polyether compound according to the first aspect of the present invention, represented by the following formula (4A'), in which the organic compound RHₘ containing **m** pieces of active hydrogen in a molecule is prepared by reacting a polybasic acid anhydride with a compound represented by the following formula (3A) prepared by carrying out a reaction between a compound represented by the following formula (2A) and carboxylic acids, alcohols, phenols, amines, thiols, or silanols (they are represented by R*Hₘ, where **m** is an integer of 1 to 30). 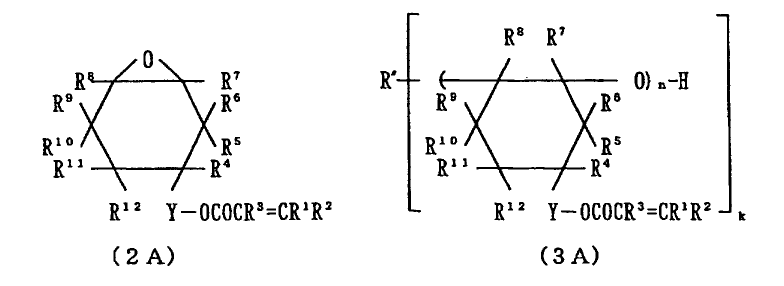 [In the formula (2A):
R¹ and R² are hydrogen atoms, and R³ is a hydrogen atom or a methyl group;
R⁴ to R¹² are each a hydrogen atom, a methyl group, an ethyl group, or a propyl group; and
Y is any one of the following structural formulas

   -(CH₂)ₙ₁-,

   -(CH₂)ₙ₁-(OCO(CH₂)₄)ₙ₂-,

   -(CH₂)ₙ₁-(OCO(CH₂)₅)ₙ₂-,

   and

   -(CH₂)ₙ₁-(OCOCH₂-CH(CH₃)-(CH₂)₂)ₙ₂-
(where **n1** is 1 to 6, hydrogen may be partially substituted with a methyl group, an ethyl group, or a propyl group, and **n2** is 1 to 10]
[In the formula (3A):
R" is a residue -R*Hₘ₋ₖ of carboxylic acids, alcohols, phenols, amines, thiols, or silanols (where **m** is an integer of 1 to 30 and **k** is 1 to **m**);
R¹ to R¹² and Y are the same as those of the formula (2A); and
**n** is an integer of 1 or more and the total of **n** in a molecule is 2 to 50] 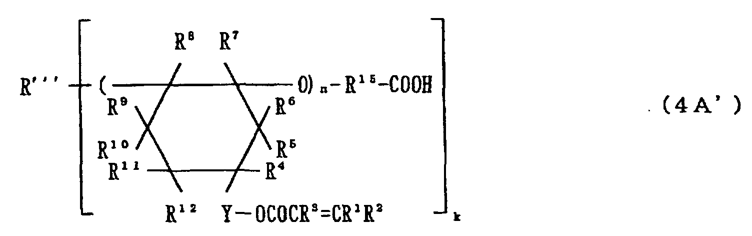
[In the formula (4A'):
R"' is a residue -R*Hₘ₋ₖ or a group derived from a reaction of the residue with a polybasic acid anhydride;
R¹ to R¹², Y, and **n** are the same as those of the formula (3A); and
R¹⁵ is a residue of a polybasic acid anhydride.]

According to a seventh aspect of the present invention, there is provided a polyether compound according to any one of the first to sixth aspects of the present invention, in which the organic compound containing **m** pieces of active hydrogen in a molecule is trimethylol propane.

According to an eighth aspect of the present invention, there is provided a polyether compound according to the sixth or seventh aspect of the present invention, in which the compound represented by the formula (2A) is 3,4-epoxycyclohexylmethyl (meth)acrylate.

According to a ninth aspect of the present invention, there is provided a polyether compound according to any one of the first to eighth aspects of the present invention, in which an acid value (solid content-corresponding value) is 5 to 150 KOHmg/g.

According to a tenth aspect of the present invention, there is provided a curable resin composition characterized by containing the polyether compound according to any one of the first to ninth aspects of the present invention, another curable resin, and/or an ethylenic unsaturated compound.

According to an eleventh aspect of the present invention, there is provided a curable resin composition according to the tenth aspect of the present invention, in which the other curable resin is a resin obtained by adding a (meth)acrylic acid/(meth)acrylate copolymer with the compound represented by the formula (2A) described in the sixth aspect of the present invention.

According to a twelfth aspect of the present invention, there is provided a cured article obtained by curing the curable resin composition according to the tenth or eleventh aspect of the present invention.

According to a thirteenth aspect of the present invention, there is provided a process for producing a polyether compound represented by the formula (4) described in the first aspect of the present invention, including the steps of:
reacting an organic compound RHₘ containing **m** pieces of active hydrogen in a molecule (where **m** is 1 to 30) with a compound represented by the following formula (2) to obtain a compound represented by the following formula (3): 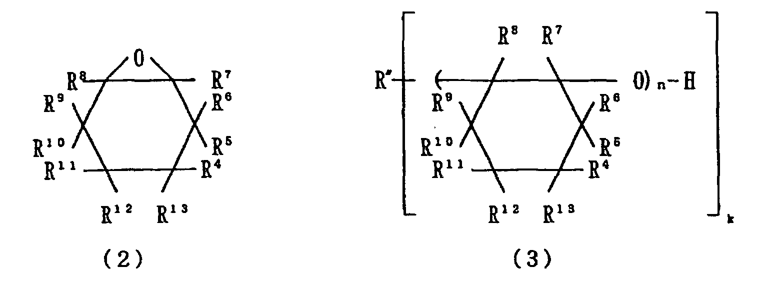
[In the formula (2),
R⁴ to R¹³ are each a hydrogen atom, a C₁-C₁₀ hydrocarbon group, or a C₁-C₁₀ hydrocarbon group having a polymerizable unsaturated group (where the polymerizable unsaturated group contains -OCO-CR³=CR¹R², R¹ and R² are hydrogen atoms, R³ is a hydrogen atom or a C₁-C₁₀ hydrocarbon group, and another group may be placed between the hydrocarbon group and -OCO-CR³=CR¹R²), and at least one of R⁴ to R¹³ is a C₁-C₁₀ hydrocarbon group having the polymerizable unsaturated groups]
[In the formula (3):
R" is a residue -RHₘ₋ₖ of an organic compound containing m active hydrogens in a molecule (where **m** is an integer of 1 to 30 and **k** is 1 to **m**);
R⁴ to R¹³ are the same as those of the formula (2); and
**n** is an integer of 1 or more and the total of **n** in a molecule is 2 to 50]; and
reacting the compound represented by the formula (3) obtained as described above with any one of a polybasic acid anhydride, phosphoric acid,ethylphosphate,diethylphosphate,monoalkylester or dialkyl ester of glucose phosphate, sulfuric acid, methyl sulfate, and ethyl sulfate.

According to a fourteenth aspect of the present invention, there is provided a process for producing a polyether compound according to the thirteenth aspect of the present invention, in which a chemical equivalent ratio (the compound represented by the formula (3)/the polybasic acid anhydride) is 1 to 30.

According to a fifteenth aspect of the present invention, there is provided a process for producing a polyether compound according to the thirteenth or fourteenth aspect of the present invention, further including ventilation of a reaction system with a gas mixture containing oxygen.

According to a sixteenth aspect of the present invention, there is provided an image-forming material containing the polyether compound represented by the formula (4) described in the first aspect of the present invention, other curable resin, and/or an ethylenic unsaturated compound as essential ingredients.

According to a seventeenth aspect of the present invention, there is provided an image-forming material according to the sixteenth aspect of the present invention, in which the other curable resin is a resin obtained by adding a (meth)acrylic acid/(meth)acrylate copolymer with the compound represented by the formula (2A) described in the sixth aspect of the present invention.

### Brief Description of the Drawings

Fig. 1 is a ¹H-NMR chart of a compound corresponding to the formula (3) obtained in Example 1.
Fig. 2 is a ¹H-NMR chart of a compound corresponding to the formula (4) obtained in Example 1.

### Best Mode for carrying out the Invention

Hereinafter, the embodiments of the present invention will be described.

### Initiator (Organic compound having active hydrogens: RHₘ)

In the first step of synthesizing a polyether compound containing an unsaturated group, which is a target compound of the present invention, an organic compound RHₘ having one or more active hydrogens in a molecule can be used as a raw material. Examples of the organic compound include carboxylic acids, alcohols, phenols, amines, thiols, and silanols.

Specific examples of the carboxylic acids include: formic acid, acetic acid, propionic acid, butyric acid, and fatty acids obtained from animal and vegetable oils; fumaric acid; acrylic acid; methacrylic acid; maleic acid; itaconic acid; succinic acid; adipic acid; azelaic acid; phthalic acid; isophthalic acid; terephthalic acid; hexahydrophthalic acid; methylhexahydrophthalic acid; tetrahydrophthalic acid; trimellitic acid; pyromellitic acid; biphenyl tetracarboxylic acid; diphenylether tetracarboxylic acid; diphenylsulfone tetracarboxylic acid; tetracarboxy benzophenone; β-carboxyethyl (meth)acrylic acid; 2-(meth)acryloyloxyethyl succinic acid; 2-(meth)acryloyloxyethyl hexahydrophthalic acid; 2-(meth)acryloyloxyethyl phthalic acid; 2-(meth)acryloyloxyethyl hydrogenphthalate; and 2-(meth)acryloyloxypropyl hydrogenphthalate, or the like.

Specific examples of the alcohols include: aliphatic alcohols such as methanol, ethanol, propanol, butanol, hexanol, and octanol; aromatic alcohols such as benzyl alcohol; polyhydric alcohols such as ethylene glycol, diethylene glycol, triethylene glycol, polyethylene glycol, propylene glycol, dipropylene glycol, 1,3-butanediol, 1,4-butanediol, pentanediol, 1,6-hexanediol, neopentyl glycol, oxy pivalate neopentyl glycol ester, cyclohexanedimethanol, glycerin, diglycerin, polyglycerin, trimethylolpropane, trimethylolehtane, pentaerythritol, dipentaerythritol, hydrogenated bisphenol A, hydrogenated bisphenol F, and hydrogenated bisphenol S; and other (meth) acrylate monomers such as 2-hydroxyethyl acrylate and 2-hydroxyethyl methacrylate.

Examples of the phenols include phenol, cresol, catechol, pyrogallol, hydroquinone, hydroquinone monomethylether, bisphenol A, bisphenol F, bisphenol S, 4,4-dihydroxybenzophenone, a phenol resin, and a cresol novolak resin.

Examples of the amines include monomethylamine, dimethylamine, monomethylamine, monoethylamine, diethylamine, propylamine, monobutylamine, dibutylamine, benzylamine, hexylamine, cyclohexylamine, octylamine, dodecylamine, 4,4-diaminodiphenylmethane, isophoronediamine, toluenediamine, hexamethylenediamine, xylenediamine, diethylenetriamine, triethylenetetramine, and ethanolamine, or the like.

Examples of the thiols include methylmercaptan, ethylmercaptan, propylmercaptan, and phenylmercaptan.

Further, examples of a compound having one or more active hydrogens include silicone compounds having silanol groups, polyvinylalcohols, partially-hydrolyzed polyvinyl acetates, starch, cellulose, cellulose acetate, cellulose acetate butyrate, hydroxyethyl cellulose, acryl polyol resins, styrene/allyl alcohol copolymer resins, styrene/maleic acid copolymer resins, alkydresins, polyester polyol resins, polyester-carboxylic acid resins, polycaprolactone polyol resins, polypropylene polyols, polytetramethylene glycols, polycarbonate polyols, polybutadienes having hydroxyl groups, and cellulose polymers such as hydroxyethyl cellulose and cellulose acetate.

Any of those compounds each having one or more active hydrogens can be used and two or more of them may be mixed together. It is to be noted that without using the compound RHₘ, the polyether compound represented by the formula (3) may be formed by exerting the water content in the raw material as an initiator.

A catalyst is used preferably when the compound RHₘ is reacted with the compound represented by the formula (2). Examples of the catalyst include Lewis acids such as BF₃, ZnCl₂, AlCl₃, and SnCl₄ or complexes thereof. Optical cation catalysts such as sulfonium and ionium, which generate acid by photoirradiation, can be also used. Those catalysts are used in amounts of preferably 0.01 to 10% by weight, particularly 0.1 to 5% by weight based on the reactants. An amount of the catalyst to be used of less than 0.01% by weight is unfavorable because the reaction takes a long time. In addition, an amount of more than 10% by weight is unfavorable because a side reaction tends to occur and the product is discolored or gelated.

### Synthesis of unsaturated group-containing Polyether Compound (3)

The reaction between the compound RHₘ and the compound represented by the formula (2) requires the use of the epoxy group of the compound represented by the formula (2) at an equivalent ratio of 3 to 50, particularly preferably 5 to 30 based on one chemical equivalent of active hydrogen. An equivalent ratio of less than 3 is unfavorable because the coating hardness of the cured article decreases when the resulting polyether compound is provided as a curing composition. An equivalent ratio in excess of 50 is unfavorable because the cured article becomes easily gelated and the viscosity of the liquid becomes so high that the sensitivity deteriorates at the time of handling or curing by ultraviolet ray.

Furthermore, the reaction time is preferably 0.5 to 24 hours, particularly preferably 2 to 5 hours. The reaction temperature is preferably -50 to 100°C, particularly preferably -20°C to 50°C. If the reaction temperature exceeds 100°C, gelation tends to occur and discoloration becomes intense.

For preventing the gelation and discoloration, solvents having no active hydrogens as described in JP 04-164921 A and JP 04-258617 A mentioned hereinabove may be used. The solvents include: ketones such as methylethyl ketone and methylisobutyl ketone; aromatic solvents such as benzene, toluene, and xylene; ethers; aliphatic hydrocarbons; and esters, or the like.

In addition to propylene glycol diacetate, propylene glycol methylether acetate, and so on, an acryl monomer or the like having no active hydroxyl group or active carboxyl groups may be used, but it is desirable to use hydrocarbons including toluene and xylene.

The amount of the solvent to be used is 0.2- to 5-folds by volume, preferably 0.5- to 3-folds by volume based on the starting raw material on the basis of weight ratio. A proportion of the solvent to be used of less than 0.2-fold by volume is not favorable because the viscosity of the product increases and heat of reaction is hardly removed, resulting in discoloring of the product obtained. In contrast, a proportion exceeding 5-folds by volume is not favorable because the curing rate lowers in a curable resin composition containing a polyether compound simultaneously containing two or more polymerizable unsaturated groups and one or more acid groups together in a molecule, which is represented by the formula (4) described later, lowers and physical properties deteriorate in the cured article.

Furthermore, JP 04-258617 A describes that a polymerization inhibitor such as hydroquinone, hydroquinone monomethylether, methyl hydroquinone, p-benzoquinone, or phenothiazine should be added to a reaction solution in a concentration of 50 to 10,000 ppm. However, a polymerization inhibitor having an active hydrogen reacts with a substrate during the synthesis and thus the effects of the inhibitor will disappear. Therefore, in the production process of the present invention, it is preferable to ventilate with oxygen-containing gas such as atmospheric air at the time of the reaction to prevent gelation. If there is no ventilation with the oxygen-containing gas, the gelation occurs as the equivalent ratio of the formula (2) increases even though the gelation hardly occurs when the equivalent ratio of the compound represented by the formula (2) is less than 2 based on one equivalent of the compound RHₘ. For industrial production, for safety, it is desirable to mix nitrogen with air to make and use a gas mixture with oxygen concentration of about 7%.

It is to be noted that in the reaction of the active hydrogen-containing compound RHₘ with the compound represented by the formula (2), an oxirane ring may be opened on the R⁸ side of oxirane oxygen or may be opened on the R⁷ side of oxirane oxygen. Furthermore, the same holds true for the reaction of the compound represented by the formula (2) with the product to generate a polyether compound. The formula (3) of the present specification is represented as if all of the ring-opening events occur on the R⁸ side of oxirane oxygen.

### Unsaturated group-containing alicyclic epoxy compound [Compound Represented by the Formula (2)]

Examples of the compound represented by the formula (2) include 3,4-epoxycyclohexylmethyl(meth)acrylate and ε-caprolactone-modified 3,4-epoxylcyclohexyl methyl(meth)acrylate. Although not represented by the formula (2), vinylhexene monoepoxide, cyclohexene oxide, α-pinene oxide, an epoxidized tetrahydrobenzyl alcohol, a caprolactone-modified epoxidized tetrahydrobenzyl alcohol, or the like can be also used as is the case with the compounds represented by the formula (2).

Of those, 3,4-epoxycyclohexylmethyl(meth)acrylate (available from Daicel Chemical Industries, Ltd., Cyclomer A-200, or the like) is preferable.

### Synthesis of polyether compound (4) containing acid groups and unsaturated Groups

The polyether compound of the formula (3) obtained as described hereinabove is further reacted with a polybasic acid anhydride, resulting in being obtainable a polyether compound having two or more polymerizable unsaturated groups, one or more acid groups, and the like in a molecule represented by the formula (4) according to the present invention.

### Polybasic acid anhydride and others

The polybasic acid anhydride is not particularly limited and either saturated and unsaturated polybasic acid anhydrides or dibasic acid anhydrides already containing acid groups such as carboxyl groups may be used. Examples of such a polybasic acid anhydride may include: succinic anhydride, maleic anhydride, phthalic anhydride, nadic anhydride, tetrahydrophthalic anhydride, tetrabromophthalic anhydride, hexahydrophthalic anhydride, methyltetrahydrophthalic anhydride, methylhexahydrophthalic anhydride, endomethylene tetrahydrophthalic anhydride, methylendomethylene tetrahydrophthalic anhydride, methylbutenyl tetrahydrophthalic anhydride, itaconic anhydride, octenyl succinic anhydride, pentadodecyl succinic anhydride, chlorendic anhydride, biphenyltetracarboxylic dianhydride, diphenylethertetracarboxylic dianhydride, butanetetracarboxylic dianhydride, cyclopentanetetracarboxylic dianhydride, trimellitic anhydride, HET anhydride, himicanhydride, adipic anhydride, azelaic anhydride, sebacic anhydride, pyromellitic anhydride, and benzophenonetetracarboxylic dianhydride, or the like. Of those, succinic anhydride, phthalic anhydride, tetrahydro phthalic anhydride, and methyltetrahydrophthalic anhydride are suitably used, and an alicyclic polybasic acid anhydride is particularly preferable. The polybasic acid anhydride in the present invention may be used solely or in combination with one or two or more different types.

A polybasic acid anhydride contains preferably an alicyclic group.

More specifically, when the polybasic acid anhydride used is 1,2,3,6-tetrahydrophthalic anhydride, 3,4,5,6-tetrahydrophthalic anhydride, 3- or 4-methyltetrahydrophthalic anhydride, hexahydrophthalic anhydride, or 3- or 4-methylhexahydrophthalic anhydride, the polyether compound of the formula (4) to be obtained is one having the following structure where X is -COOH. 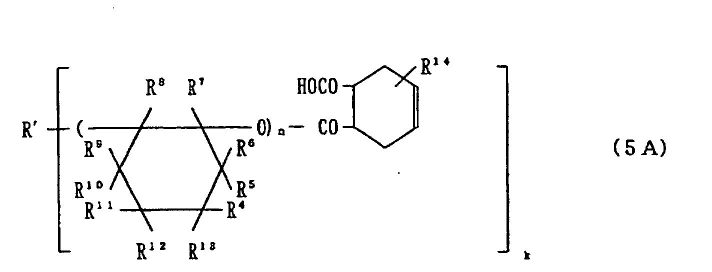 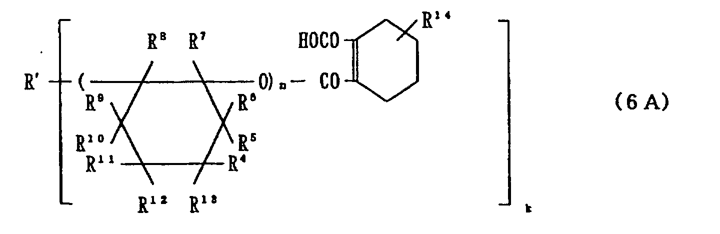 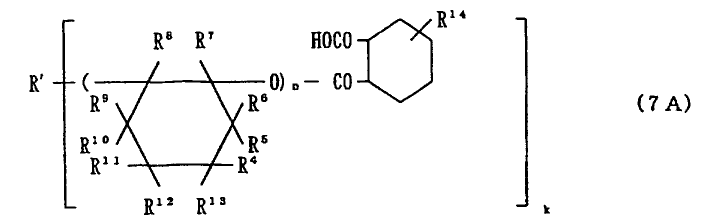 [In the formulas (5A), (6A), and (7A), R¹⁴ is a hydrogen atom or an alkyl group such as a methyl group.]

In the formula (4), if X is -PO(OH)ₐ(OR)_{b}, phosphoric acid, monoalkyl ester such as ethyl phosphate, diethyl phosphate, or glucose phosphate, dialkyl ester, or the like (phosphoric acids) is used instead of the polybasic acid anhydrides.

In the formula (4), furthermore, if X is -SO₃R, sulfuric acid, acidic sulfate such as ethyl sulfate or methyl sulfate (sulfuric acids) is used instead of the polybasic acid anhydrides.

Furthermore, the reaction with the polybasic acid anhydrides, phosphoric acids, or sulfuric acids may be carried out such that a reactive diluent is used as it is without isolating a reaction medium used in synthesizing the polyether compound of the formula (3), and it may be also carried out after isolating the reactive diluent.

Further, a polybasic acid anhydride may be additively reacted by dissolving the polybasic acid anhydride in organic solvents including: aromatic hydrocarbons such as toluene and xylene; alcohols such as methanol, isopropanol, and cyclohexanol; alicyclic hydrocarbons such as cyclohexane and methylcyclohexane; petroleum-based solvents such as petroleum ether and petroleum naphtha; cellosolves such as cellosolve and butylcellosolve; carbitols such as carbitol and butylcarbitol; acetates such as ethyl acetate, butyl acetate, cellosolve acetate, butylcellosolve acetate, carbitol acetate, and butylcarbitol acetate; and ketones such as methyl ethyl ketone and cyclohexanon.

Further, in addition to those organic solvents, a photopolymerizable monomer may be used as a reactive diluent. Examples of the photopolymerizable monomer which may be used as a reactive diluent include: monofunctional acrylate compounds such as methyl(meth)acrylate, ethyl(meth)acrylate, n-propyl(meth)acrylate, n-butyl(meth)acrylate, 2-ethylhexyl(meth)acrylate, lauryl(meth)acrylate, stearyl(meth)acrylate, cyclohexyl(meth)acrylate, phenoxyethyl(meth)acrylate, 2-ethoxyethyl(meth)acrylate, 2-butoxyethyl(meth)acrylate, 2-hydroxyethyl(meth)acrylate, 2-hydroxypropyl(meth)acrylate, benzyl(meth)acrylate, ethylene glycol mono(meth)acrylate, and ethylcarbitol(meth)acrylate; and polyfunctional acrylates such as ethylene glycol di (meth) acrylate, polyethylene glycol di(meth)acrylate, neopentyl glycol di(meth)acrylate, trimethylol propane di(meth)acrylate, trimethylol propane tri(meth)acrylate, pentaerythritol tri(meth)acrylate, pentaerythritol tetra(meth)acrylate, dipentaerythritol penta(meth)acrylate, dipentaerythritol hexa(meth)acrylate, and polyfunctional epoxy acrylates. It is to be noted that (meth)acrylates represent both acrylates and methacrylates.

In the present invention, each of those reactive diluents may be used by itself or they may be used in combination of two or more of them. In the present invention, thereactionbetweenthepolyether compound of the formula (3) and the polybasic acid anhydride is preferably carried out under ventilation with mixed gas containing oxygen in the presence of a polymerization inhibitor such as hydroquinone or methoquinone at temperatures of 80 to 120°C. If the reaction temperature is lower than 80°C, the reaction rate becomes slow and thus the reaction may take a longer time. If the reaction temperature exceeds 120°C, polyfunctional acrylate causes thermal polymerization and thus gelation may occur during the reaction. At this time, tertiary amine such as triethyl amine, quaternary ammonium salt such as triethylbenzyl ammonium chloride, an imidazol compound such as 2-ethyl-4-methyl imidazole, a phosphorus compound such as triphosphine, or the like may be optionally added as a catalyst.

As is evident from the synthetic process described above, the polyether compound of the present invention can be represented by the formula (4) described above.

In the formula (4), the total of **n** in one molecule is 2 to 50, preferably 5 to 20. However, the respective **k** pieces of structures may be identical to or different from each other and ''n'' in each of the structures may be identical to or different from each other. If the total of **n** is more than 50, the number of unsaturated groups in the polyether compound represented by the formula (4) increases unnecessarily. If the polyether compound is used as a curable resin, it is not favorable because the density of the cross links becomes too high and the resulting cured layer becomes brittle.

In addition, the acid value (solid content-corresponding values) of the polyether compound represented by the formula (4) is generally 5 to 150 KOHmg/g, preferably 25 to 150 KOHmg/g, further preferably 45 to 140 KOHmg/g in consideration of alkali developability or sensitivity. If the acid value is less than 5 KOHmg/g, when the polyether compound is used as a solder-photoresist ink composition, the developability with dilute alkali may be reduced. If the acid value exceeds 150 KOHmg/g, when the polyether compound is a curable resin composition, storage stability may be reduced.

It is to be noted that when a polyvalent compound in which **m** is equal to or larger than 2 is used as the organic compound RHₘ having **m** pieces of active hydrogen in a molecule, various cases may arise, for example, in addition to -RHₘ₋ₖ where the active hydrogen of R' in the above formula (4) reacts with **k** pieces of the compound represented by the above formula (2) and then **m-k** pieces of them remain, the remaining active hydrogens react with a polybasic acid compound or the like. The R" in the above formula (3) is the same as the R' . In the present specification, "group derived from the residue" means such a case.

As a specific example, if the compound of the formula (3) is considered to be a case where trimethylol propane is used as an organic compound containing **m** pieces of active hydrogen in a molecule, in addition to the case where R" is a residue CH₃CH₂C(CH₂OH)₂CH₂O- (all of the remaining active hydrogens are unreacted) , one or all of two active hydrogens in the residue may be respectively provided as the origin of a reaction, on which the compound of the formula (2) is reacted. In other words, there is provided the "group derived from the residue" having one or two structures corresponding to those of removing R" from the formula (3). If all of two active hydrogens in the residue are reacted, there may be provided the above-mentioned three structures in total (branching as the entire molecule). Also in the ether compound corresponding to the formula (4) obtained by further reacting a polybasic acid anhydride or the like with the compound corresponding to the formula (3) in the case of trimethylol propane, there may be provided the same structures.

### Resin Composition

The resin composition of the present invention is preferably one containing at least 15% by weight of a polyether compound represented by the above (4). An example of the resin composition of the present invention is a blended composition between the polyether compound of the present invention and a curable resin and/or an ethylenic unsaturated compound obtained by the addition of a compound represented by the formula (2A) on a (meth)acrylic acid/(meth)acrylate copolymer.

Specific examples of the curable resin include "ACA200 or Cyclomer P" manufactured by Daicel Chemical Industries, Ltd.

Specific examples of the unsaturated ethylenic unsaturated compounds include β-carboxyethyl(meth)acrylate, isobonyl(meth)acrylate, octylnodecyl(meth)acrylate, ethoxyphenyl(meth)acrylate, diethyleneglycol monoethylether(meth)acrylate, t-butylcyclohexyl(meth)acrylate, dipropyleneglycol di(meth)acrylate, 1,6-hexanediol di(meth)acrylate, tripropylene glycol di(meth)acrylate, modified bisphenol A di(meth)acrylate, dimethylol dicyclopentane di(meth)acryalte, each type of PEG di(meth)acrylate, tetraethylene glycol di(meth)acrylate, trimethylolpropane tri(meth)acrylate, trimethylolpropane ethoxy tri(meth)acrylate, glycerin propoxy tritri(meth)acrylate, caprolactone-modified trimethylolpropane tri(meth)acrylate, pentaerythritol ethoxy tetra(meth)acrylate, ditrimethylolpropane tetra(meth)acrylate, pentaerythritol tetra(meth)acrylate, dipentaerythritol hexa(meth)acrylate, lauryl(meth)acrylate, butanediol di(meth)acrylate, bisphenol A ethoxylate di(meth)acrylate, diethylene glycol di(meth)acrylate, triethylene glycol di(meth)acrylate, lactone-modified flexible (meth)acrylate, 2-ethylhexyl(meth)acrylate, 2-hydroxyethyl(meth)acrylate, 2-hydroxypropyl(meth)acrylate, 2-hydroxyethyl(meth)acryloylphosphate, neopentyl glycol di(meth)acrylate, and hydroxy vivarate neopentyl glycol di(meth)acrylate, or the like. Those ethylenic unsaturated compounds may be synthesized using any known method, and are easily available from the market.

Further, the polyether compound represented by the formula (4) may be used in combination with other polymerizable oligomers such as each type of an epoxy acrylate, a urethane (meth) acrylate, unsaturated polyesters, polyester(meth)acrylates, polyether(meth)acrylates, and polymers thereof.

One type or two or more types of the resin and/or ethylenic unsaturated compound obtained by the addition of the compound represented by the formula (2A) on the (meth)acrylic acid/(meth)acrylate copolymer can be used in mixture at a given ratio if needed.

The usage amount of the resin and/or ethylenic unsaturated compound obtained by the addition of the compound represented by the formula (2A) on the (meth) acrylic acid/(meth)acrylate copolymer is preferably 1 to 85% by weight, preferably 10 to 80% by weight in the resin composition.

### Curing of the Resin Composition

The resin composition of the present invention can be cured by heat. Alternatively, the resin composition can be cured by irradiation with active energy rays such as ultraviolet rays, electron beams, X-rays, and γ-rays. Curing with ultraviolet rays is most popular. For example, curing is easily attained by irradiation with ultraviolet rays through a low-pressure or high-pressure mercury-vapor lamp or a xenon lamp.

The resin composition of the present invention is useful as a coating agent, paint, ink, resist, or the like for various kinds of substrates including paper, metal, plastics, glass, ceramics, concrete, and wood, or the like. For curing with ultraviolet rays, in general, a photopolymerization initiator is used.

Although any publicly-known photopolymerization initiator may be used as the photopolymerization initiator, excellence in storage stability after blending is required. Examples of such a photopolymerization initiator include: benzoinalkylether-based ones such as benzoinethylether, benzoinisobutylether, and benzoinisopropylether; acetophenone-based ones such as 2,2-diethoxy acetophenone and 4'-phenoxy-2,2-dichloro acetophenone; propiophenone-based ones such as 2-hydroxy-2-methylpropiophenone, 4'-isopropyl-2-hydroxy-2-methylpropiophenone, and 4'-dodecyl-2-hydroxy-2-methylpropiophenone; anthraquinone-based ones such as benzyldimethylnatal, 1-hydroxycyclohexyl phenyl ketone, 2-ethylanthraquinone, and 2-chloroanthraquinone; and other thioxanthone photopolymerization initiators.

Each of those photopolymerization initiators may be used solely or two or more of them may be mixed at a given ratio. The usage amount of the photopolymerization initiator is generally 0.1 to 30% by weight, preferably 1 to 20% by weight, more preferably 1 to 5% by weight. If the usage amount of the photopolymerization initiator is less than 0.1% by weight, the curing rate is slow and thus a device for irradiation with more strong energy is required, while there are problems in safety, productivity, and economical efficiency. In contrast, an increase in curing rate does not occur even if the amount exceeding 30% by weight is used and rather the physical properties of the cured article decrease. Thus, an excessively low or high amount is not favorable.

The resin composition of the present invention can optionally use a polymerization inhibitor, a silane-coupling agent, an antioxidant, an optical stabilizer, a plasticizer, a leveling agent, an antifoaming agent, a pigment, an inorganic filler, or an organic solvent. The resin composition of the present invention can be obtained by uniformly mixing respective ingredients.

Methods of applying the resin composition of the present invention on a substrate include a spin coating method, a roll coating method, a dipping method, a spraying method, a curtain flow coating method, a screen printing method, an offset printing method, and a gravure coating method.

The resin composition of the present invention can be used as an image-forming material by optionally mixing with a curable resin except the other curable resins described above.

### Examples

Hereinafter, the present invention will be described more specifically with reference to the examples, but the present invention is not limited to these examples.

It is to be noted that "parts" used in the examples and comparative examples means "parts by weight".

### (Example 1)

Fed in a 5-litter reactor equipped with a stirrer, a thermostat, and a thermometer were 134.2 parts of trimethylol propane (TMP), 2,730 parts of 3,4-epoxycyclohexyl methylacrylate which is a compound having the structure represented by the formula (2), (available from Daicel Chemical Industries, Ltd., Cyclomer A-200), and 1,540 parts of toluene. The solution was heated up to 35°C, and then 41 parts of a diethyl ether complex of boron trifluoride was dropped in the solution over about 3 hours to carry out a reaction. After the completion of the dropping, the reaction was allowed to proceed until the content of oxirane oxygen in the mixture solution would become 0.05% or less. In order to prevent gelation to be caused by radical polymerization during the reaction until the completion of the reaction, a gas mixture composed of nitrogen and the air, in which the oxygen content was 7%, was supplied into the solution at a rate of 83 ml/minute.

The solid content (residue dried at 120°C for 1 hour), viscosity, and molecular weight with GPC of the resulting compound corresponding to the formula (3) (herein referred to as a polyacrylate compound) are as follows: a solid content of 65.4%, a viscosity (25°C) of 181 cps, an acid value of 2.5 KOHmg/g, Mw = 3,640, and Mn = 1,760.

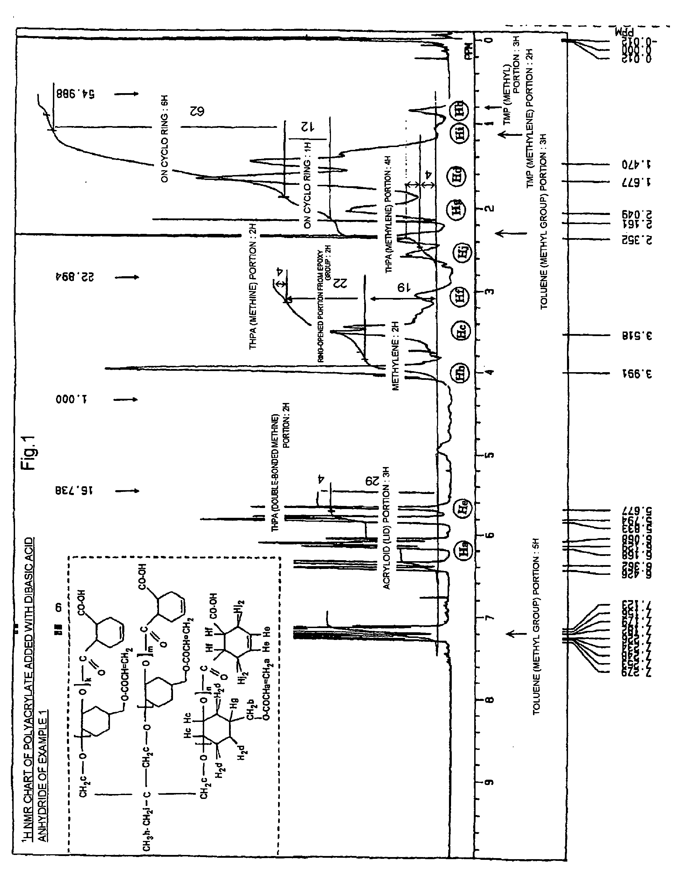

The structure of the obtained polyacrylate compound in the state of a toluene solution was identified by ¹H-NMR measurement. Fig. 1 shows the NMR chart.

In the NMR chart in Fig. 1, the proton peaks by the solvent toluene are 7.2 ppm (the peak is partially defected by the chemical formula) and 2.3 ppm. The absorbance by the polyacrylate compound obtained in the above description includes a peak with acryloyloxy group at 6.4 to 5.8 ppm (3H) (hereinafter, the number of protons is represented in parentheses), a peak by methylene sandwiched between a cyclo ring and acryloid at 4 ppm (2H), and a main peak by a ring-opened portion from epoxy group at 3.5 ppm (2H). In addition, the proton by methylene adjacent to the hydroxyl group of TMP and the proton by the end hydroxyl group of the resin overlap.

Furthermore, 2.0 ppm (1H) is the proton attached to the tertiary carbon on the cyclo ring, and a peak at 1.9 to 1.2 ppm (6H) is a peak by the proton attached to the secondary carbon on the cyclo ring. It can be confirmed that the proton intensity ratio of each group corresponds to almost a theoretical value, and the complete ring-opening of epoxy groups of the formula (2) can be recognized.

In addition, the ratio of the absorption intensity at 0.9 ppm by the methyl group (3H) of trimethylolpropane used as an initiator for ring-opening to the intensity of 1H proton attached to the tertiary carbon on the previous cyclo ring is 2 : 10, so that it can be confirmed that the ratio is equal to a theoretical value obtained from a feeding mol ratio of 1:15.

The polyacrylate compound obtained as described above was further subjected to an addition reaction with tetrahydrophthalic anhydride, which was a dibasic acid anhydride, as follows.

Fed in a 500-ml reactor equipped with a stirrer, a thermostat, and a thermometer were 300 parts of a polyacrylate compound-containing toluene solution (solid content: 65%), 31 parts of tetrahydrophthalic anhydride, and 0.33 part of hydroquinone monomethylether. The solution was heated up to 90°C, and then 0.83 part of imidazole was added to proceed an addition reaction, while samples were collected with a lapse of time during the reaction and then subjected to the measurement of acid value and GPC, respectively. The reaction was performed for 10 hours, and it was confirmed that the acid value was 36 KOHmg/g (solid content-corresponding acid value = 51 KOHmg/g) in contrast to a theoretical value of 35 KOHmg/g in this reaction and peaks at lower molecular weight with tetrahydrophthalic anhydride substantially disappeared in the GPC measurement.

The solid content (dried at 120°C for 1 hour), viscosity, and molecular weight with GPC of the obtained polyether compound of the formula (4) (herein referred to as an acid anhydride-added polyacrylate compound) were as follows: a solid content of 69.2%, a viscosity (25°C) of 1,600 cps, Mw = 3,740, and Mn = 1,810.

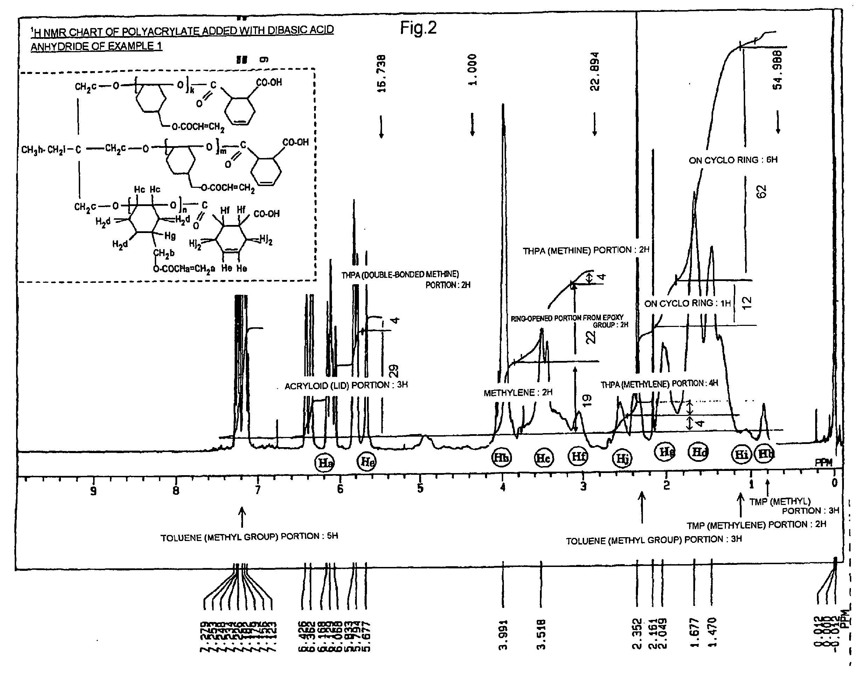

The structure of the polyacrylate compound added with dibasic acid anhydride was identified by ¹H-NMR measurement in the state of a toluene solution. Fig. 2 shows the NMR chart.

In the NMR chart of Fig. 2, comparing with the NMR chart in Fig. 1, the following three peaks caused by tetrahydrophthalic anhydride (THPA) are added. At first, a peak at 5.7 ppm is caused by a methine proton of the double bond portion in THPA, and a peak at 3.0 ppm is caused by the methine proton adjacent to the ester of THPA. Those two peaks can be observed at 6.0 ppm and 3.4 ppm respectively in THPA alone and the sample at an initial stage of the reaction, but their peak positions are shifted by the result of binding with a polyacrylate compound. Finally, the absorbance by the methylene portion (4H) of THPA is observed such that the absorbance is divided into 2.6 ppm (2H) and 2.3 ppm (2H). It was confirmed that the peak at 2.3 ppm overlapped the absorption by the methyl group of toluene medium and the proton intensity ratios of 5.7, 3.0, and 2.6 ppmwere almost equal to one another. In addition, the ratio between those intensities and the intensity at 4.0 ppm by methylene sandwiched between the acryloyl group and the cyclo ring is 4:19, so that it can be confirmed that the ratio is equal to a value obtained from a feeding mol ratio of 3:15.

### (Example 2)

Fed in a 3-litter reactor equippedwith a stirrer, a thermostat, and a thermometer were 134.2 parts of trimethylol propane (TMP), 1,092 parts of 3, 4-epoxycyclohexyl methylacrylate mentioned above, and 650 parts of toluene. The solution was heated up to 35°C, and then 16.4 parts of a diethyl ether complex of boron trifluoride was dropped in the solution over about 3 hours to carry out a reaction. After the completion of the dropping, the reaction was allowed to proceed until the content of oxirane oxygen in the solution mixture would become 0. 05% or less. In order to prevent gelation to be caused by radical polymerization during the reaction until the completion of the reaction, a gas mixture composed of nitrogen and the air, in which the oxygen content was 7%, was supplied into the solution at a rate of 50 ml/minute.

The solid content (residue dried at 120°C for 1 hour) , viscosity, and molecular weight with GPC of the resulting polyacrylate compound are as follows: a solid content of 64.5%, a viscosity (25°C) of 98 cps, an acid value of 2.0 KOHmg/g, Mw = 1,410, and Mn = 1,020.

The resulting polyacrylate compound was further subjected to an addition reaction with tetrahydrophthalic anhydride as follows.

Fed in a 500-ml reactor equipped with a stirrer, a thermostat, and a thermometer were 300 parts of a polyacrylate compound-containing toluene solution (solid content: 65%), 72.5 parts of tetrahydrophthalic anhydride, and 0.33 part of hydroquinone monomethylether. The solution was heated up to 90°C, and then 0.83 part of imidazole was added to proceed an addition reaction, while samples were collected with a lapse of time during the reaction and then subjected to the measurement of acid value and GPC, respectively. The reaction was performed for 10 hours, and it was confirmed that the acid value was 74 KOHmg/g (solid content-corresponding acid value = 103 KOHmg/g) in contrast to a theoretical value of 72 KOHmg/g in this reaction and peaks at lower molecular weight with tetrahydrophthalic anhydride substantially disappeared in the GPC measurement.

The solid content (dried at 120°C for 1 hour) , viscosity, and molecular weight with GPC of the resulting acid anhydride-added polyacrylate compound are as follows: a solid content of 71.8%, a viscosity (25°C) of 1,150 cps, Mw = 1,550, and Mn = 1,180.

### (Example 3)

Fed in a 3-litter reactor equipped with a stirrer, a thermostat, and a thermometer were 134.2 parts of trimethylol propane (TMP), 1,176 parts of 3,4-epoxycyclohexyl methacrylate, a compound having the structure represented by the formula (2), (available from Daicel Chemical Industries, Ltd. , Cyclomer M-100) , and 695 parts of toluene. The solution was heated up to 35°C, and then 17.6 parts of a diethyl ether complex of boron trifluoride was dropped in the solution over about 3 hours to carry out a reaction. After the completion of the dropping, the reaction was allowed to proceed until the content of oxirane oxygen in the mixture solution would become 0.05% or less. In order to prevent gelation to be caused by radical polymerization during the reaction until the completion of the reaction, a gas mixture composed of nitrogen and the air, in which the oxygen content was 7%, was supplied into the solution at a rate of 50 ml/minute. The solid content (dried at 120°C for 1 hour), viscosity, and molecular weight with GPC of the resulting polyacrylate compound are as follows.

A solid content of 65.2%, a viscosity (25°C) of 90 cps, an acid value of 1.5 KOHmg/g, Mw = 1,480, and Mn = 1,090.

The resulting polyacrylate compound was further subjected to an addition reaction with tetrahydrophthalic anhydride as follows.

Fed in a 500-ml reactor equipped with a stirrer, a thermostat, and a thermometer were 300 parts of a polymethacrylate compound-containing toluene solution (solid content: 65%), 71 parts of tetrahydrophthalic anhydride, and 0.33 part of hydroquinone monomethylether. The solution was heated up to 90°C, and then 0.83 part of imidazole was added to proceed an addition reaction, while samples were collected with a lapse of time during the reaction and then subjected to the measurement of acid value and GPC, respectively. The reaction was performed for 10 hours, and it was confirmed that the acid value was 73 KOHmg/g (solid content-corresponding acid value = 100 KOH mg/g) in contrast to a theoretical value of 71 KOHmg/g in this reaction and peaks at lower molecular weight with tetrahydrophthalic anhydride substantially disappeared in the GPC measurement.

The solid content (dried at 120°C for 1 hour) , viscosity, and molecular weight with GPC of the resulting acid anhydride-added polyacrylate compound were as follows: a solid content of 73.0%, a viscosity (25°C) of 1,460 cps, Mw = 1,570, and Mn = 1,200.

### (Example 4)

Fed in a 2-litter reactor equipped with a stirrer, a thermostat, and a thermometer were 72 parts of acrylic acid (AA), 910 parts of 3,4-epoxycyclohexyl methylacrylate mentioned above, and 520 parts of toluene. The solution was heated up to 35°C, and then 13. 7 parts of a diethyl ether complex of boron trifluoride was dropped in the solution over about 3 hours to carry out a reaction. After the completion of the dropping, the reaction was allowed to proceed until the content of oxirane oxygen in the mixture solution would become 0.05% or less. In order to prevent gelation to be caused by radical polymerization during the reaction until the completion of the reaction, a gas mixture composed of nitrogen and the air, in which the oxygen content was 7%, was supplied into the solution at a rate of 33 ml/minute. The solid content (dried at 120°C for 1 hour), viscosity, and molecular weight with GPC of the resulting polyacrylate compound are as follows.

A solid content of 65.4%, a viscosity (25°C) of 75 cps, Mw = 1,380, and Mn = 940.

The resulting polyacrylate compound was further subjected to an addition reaction with tetrahydro phthalic anhydride as follows. Fed in a 500-ml reactor equipped with a stirrer, a thermostat, and a thermometer were 300 parts of a toluene solution containing the polyacrylate compound (solid content: 65%), 30.2 parts of tetrahydrophthalic anhydride, and 0.33 part of hydroquinone monomethylether. The solution was heated up to 90°C, and then 0.83 part of imidazole was added to proceed an addition reaction, while samples were collected with a lapse of time during the reaction and then subjected to the measurement of acid value and GPC, respectively. The reaction was performed for 10 hours, and it was confirmed that the acid value was 35 KOHmg/g (solid content-corresponding acid value = 51 KOH mg/g) in contrast to a theoretical value of 34 KOHmg/g in this reaction and peaks at lower molecular weight with tetrahydrophthalic anhydride substantially disappeared in the GPC measurement.

The solid content (dried at 120°C for 1 hour) , viscosity, and molecular weight with GPC of the resulting acid anhydride-added polyacrylate compound are as follows: a solid content of 68.6%, a viscosity (25°C) of 1,230 cps, Mw = 1,440, and Mn = 1,010.

### (Comparative Example 1)

Fed in a 2-litter reactor equipped with a stirrer, a thermostat, and a thermometer were 72 parts of acrylic acid, 910 parts of 3,4-epoxycyclohexyl methylacrylate, 165 parts of toluene, and 0.91 part of hydroquinone monomethylether as a polymerization inhibitor. The solution was heated up to 35°C, and then 13.7 parts of a diethyl ether complex of boron trifluoride was dropped in the solution over about 3 hours. A reaction was expected to proceed but gelation occurred when the reaction was initiated without supplying a gas mixture composed of nitrogen and the air during the reaction.

### (Comparative Example 2)

Fed ina 2-litter reactor equippedwitha stirrer, a thermostat, and a thermometer were 72.1 parts of acrylic acid, 620 parts of vinylcyclohexene monoepoxide (available from Daicel Chemical Industries, Ltd., CEL2000), and 360 parts of toluene. The solution was heated up to 35°C, and then 12.4 parts of a diethyl ether complex of boron trifluoride was dropped in the solution over about 3 hours to carry out a reaction. After the completion of the dropping, the reaction was allowed to proceed until the content of oxirane oxygen in the solution mixture would become 0.05% or less. In order to prevent gelation to be caused by radical polymerization during the reaction until the completion of the reaction, a gas mixture composed of nitrogen and the air, in which the oxygen content was 7%, was supplied into the solution at a rate of 83 ml/minute.

The viscosity, molecular weight with GPC, and the like of the resulting compound are as follows: a solid content of 64.8%, a viscosity (25°C) of 125 cps, an acid value of 2.5 KOHmg/g, Mw = 1,890, and Mn = 950.

The compound (A) obtained as described above was further subjected to an addition reaction with tetrahydrophthalic anhydride as follows.

Fed in a 500-ml reactor equipped with a stirrer, a thermostat, and a thermometer were 300 parts of a toluene solution of the compound (A) (solid content: 65%), 42.8 parts of tetrahydro phthalic anhydride, and 0.33 part of hydroquinone monomethylether. The solution was heated up to 90°C, and then 0.83 part of imidazole was added to proceed an addition reaction, while samples were collected with a lapse of time during the reaction and then subjected to the measurement of acid value and GPC, respectively. The reaction was performed for 10 hours, and it was confirmed that the acid value was 48 KOHmg/g (solid content-corresponding acid value = 68 KOHmg/g) in contrast to a theoretical value of 46 KOHmg/g in this reaction and peaks at lower molecular weight with tetrahydrophthalic anhydride substantially disappeared in the GPC measurement.

The solid content (dried at 120°C for 1 hour) , viscosity, and molecular weight with GPC of the resulting acid anhydride-added polyacrylate compound are as follows: a solid content of 70.6%, a viscosity (25°C) of 1,260 cps, Mw = 1,990, and Mn = 1,020.

### (Comparative Example 3)

As one of the comparative examples, for obtaining an epoxy (meth) acrylate resin and an addition product thereof with am acid anhydride by subjecting the epoxy group of an epoxy resin described in JP 06-157965 A to a ring-opening reaction with acrylic acid or methacrylic acid, the following synthesis was carried out.

Fed in a 2-litter reactor equipped with a stirrer, a thermostat, and a thermometer were 1,000 parts of an epoxidized cyclohexane polyether resin EHPE3150 (an epoxidized reaction product between 1 mol trimethylol propane and 15 mol vinylcyclohexene monoepoxide, available from Daicel Chemical Industries, Ltd., epoxy equivalent: 178) manufactured by the process described in JP 60-166675 A, 602 parts of propylene glycol monomethyl ether acetate (MMPG-Ac), and 21.0 pars of dimethyl benzylamine. The mixture was heated up to 100°C to dissolve EHPE3150, and then 202 parts of acrylic acid, that is, the amount of which corresponded to the equivalent ratio between the epoxy group and the carboxyl group was dropped for 1 hour. Furthermore, sampling was performed after aging of the mixture was carried out at 100°C for 7 hours.

Measuring the acid value of a sample resulted in 26 KOHmg/g. Thus, aging was carried on for 3 hours after the temperature was heated up to 110°C, and then sampling was performed again, confirming that the acid value of the sample was 4 KOHmg/g or less. It is to be noted that for preventing the occurrence of gelation until the reaction and aging were completed, a gas mixture composed of nitrogen and air was supplied into the solution, in which the oxygen content was 7%, at a rate of 17 ml/min.

The viscosity, molecular weight with GPC, and so on of the compound obtained are as follows: a solid content of 65.5%, an acid value of 4.8 KOHmg/g, a viscosity (25°C) of 2,150 cpc, Mw = 3,270, and Mn = 1,460.

The resulting compound was further subjected to an addition reaction with tetrahydro phthalic anhydride as follows.

Fed in a 500-ml reactor equipped with a stirrer, a thermostat, and a thermometer were 300 parts of an MMPG-Ac solution of the above compound (solid content: 65%), 28.1 parts of tetrahydrophthalic anhydride, and 0.33 part of hydroquinone monomethylether. The solution was heated up to 90°C, and then 0.83 part of imidazole was added to proceed an addition reaction, while samples were collected with a lapse of time during the reaction and then subj ected to the measurement of acid value and GPC, respectively. The reaction was performed for 10 hours, and it was confirmed that the acid value was 33 KOHmg/g (solid content-corresponding acid value = 48 KOHmg/g) in contrast to a theoretical value of 32 KOHmg/g in this reaction and peaks at lower molecular weight with tetrahydrophthalic anhydride substantially disappeared in the GPC measurement.

The solid content (dried at 120°C for 1 hour), viscosity, and molecular weight with GPC of the resulting acid anhydride-added polyether compound were as follows: a solid content of 68.8%, a viscosity (25°C) of 6,350 cps, Mw = 3,570, and Mn = 1,550.

Table 1 and Table 2 summarize and show the physical properties of the reaction compositions of the examples and comparative examples and the solution mixtures obtained.

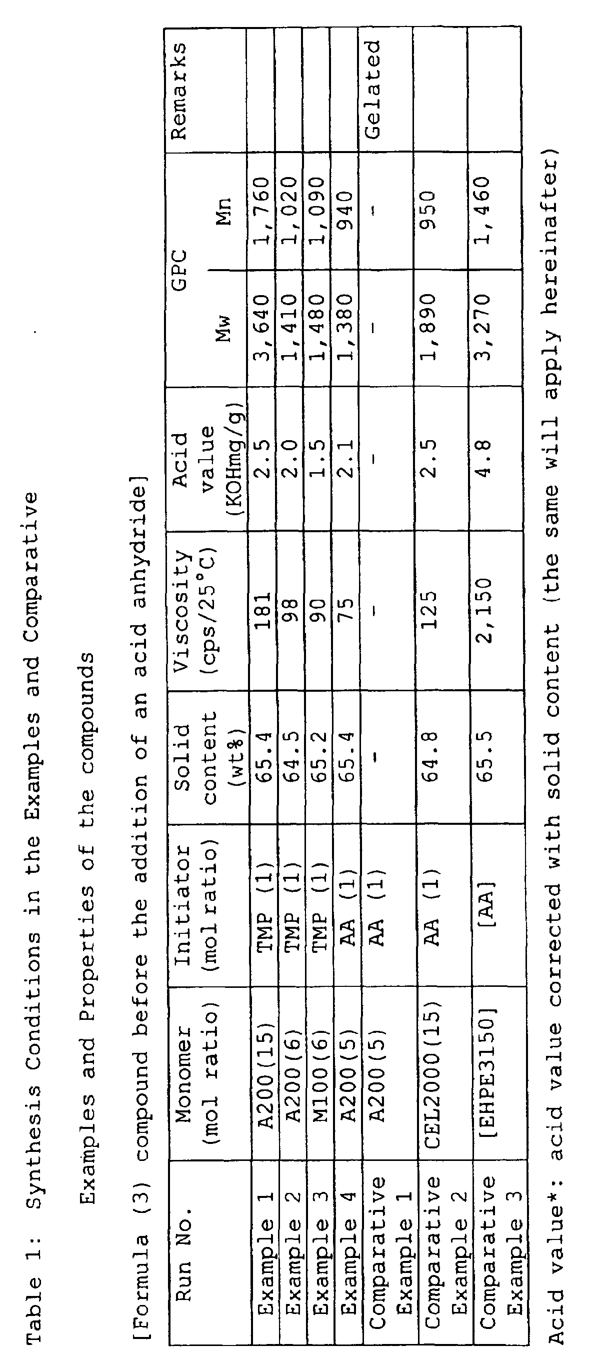

**Table 2:**

| Synthesis Conditions in the Examples and Comparative Examples and Properties of the compounds [Formula (4) compound after the addition of an acid anhydride] | | | | | | |
|---|---|---|---|---|---|---|
| Run No. | Solid content (wt%) | Viscosity (cps/25°C) | Acid value* (KOH mg/g) | GPC Mw Mn | | Remarks |
| Example 1 | 69.2 | 1,600 | 51 | 3,740 | 1,810 | |
| Example 2 | 71.8 | 1,150 | 103 | 1,550 | 1,180 | |
| Example 3 | 73.0 | 1,460 | 100 | 1,570 | 1,200 | |
| Example 4 | 68.6 | 1,230 | 51 | 1,440 | 1,010 | |
| Comparative Example 1 | - | - | - | - | - | Gelated in synthesis of the formula (3)compou nd |
| Comparative Example 2 | 70.6 | 1,260 | 68 | 1,990 | 1,020 | |
| Comparative Example 3 | 68.8 | 6,350 | 48 | 3,570 | 1,550 | |

### Evaluation of UV-Cured Article

A marketed product (available from Daicel Chemical Industries Co., Ltd., ACA200), which was prepared by subjecting a methacrylic acid/methyl methacrylate copolymer to be used in the field of alkali development type resist to an addition reaction with 3,4-epoxycyclohexyl methylacrylate of the formula (2A), was mixed with the acid-terminated acrylate compound and so on obtained in Examples 1 to 4 and Comparative Examples 2 and 3 and then cured by UV, followed by evaluating developability and so on.

In addition, the respective compositions were described as Examples 1a to 4a and Comparative Examples 2b and 3b and a mixture with the polyacrylate compound before the addition of dibasic acid anhydride of Example 1 described above was defined as Comparative Example 4b. Furthermore, a system mixed with commercially-available and publicly-used hexafunctional DPHA (dipentaerythritol hexaacrylate) having aryloyloxy groups and a system mixed with nothing were also provided for references.

Herein, ACA200 had a solid content of 47% and polyfunctional acrylates including DPHA were adjusted to 65% in content of acrylate ingredients using toluene in advance, and then prepared such that the solid content after curing in a mixture system added with a photopolymerization initiator and a colorant solution would reach about 40%.

For making the developability clear, an MMPG-Ac solution of 2.0% Orasol Bluegn was used as a colorant and Irgacure-907 (available from Chiba Specialty Chemicals, Co., Ltd.) was used as a photopolymerization initiator.

A solution mixture of them was applied on a copper plate (JIS H3100 C1160F, 03 x 50 x 150 mm) with a bar coater so as to have a dry film thickness of about 40 µm and then pre-baked at 80°C for 40 minutes, followed by subjecting to a high-pressure mercury-vapor lamp (ECS-301 manufactured by Eyegraphic Co., Ltd.) two or three times for curing with UV at a light intensity of 120 w/cm² and a line speed of 5.0 m/min (UV irradiation dose of 400 mJ/cm²).

Evaluation items include the presence or absence of tackiness and luster in prebaking (PB). Subsequently, tackiness, luster, pencil hardness, solvent resistance, and flexural resistance after UV irradiation are included. Furthermore, 1% Na₂CO₃ solution was sprayed on the cured coating layer and then the time required for development and the sensitivity were identified.

Evaluation of solvent resistance was performed by perfusing toluene and MEK into tissue paper (Kim Wipe, Trade name of Jujo Kimberly Co., Ltd.) and rubbing the coating layer after irradiation with hands for 100 times, followed by confirming the presence or absence of change on the surface thereof.

One being not changed was marked by "o", and one being any changed was marked by "×".

Evaluation of flexural resistance was performed by bending the coating film after irradiation using the axle (ϕ 10mm) of a JIS K5400 bending test device and confirming the presence or absence of cracking of the coating layer. One having no crack was marked as "o" and one having a crack was marked as "×".

For the developing time, the surface of the coating layer was partially wrapped by an aluminum foil before the irradiation with UV after prebaking and then the foil was peeled off after irradiation, followed by counting a time required for rinsing the unexposed portion.

Sensitivity was evaluated such that a step tablet was pasted before UV irradiation and the unexposed portion was rinsed with a developer after irradiation. Table 3 shows the results.

**Table 3**

| | | Example | | | | Comparative Example | | | | |
|---|---|---|---|---|---|---|---|---|---|---|
| Steps | Test No | (1) | (2) | (3) | (4) | (5) | (6) | (7) | (8) | (9) |
| Mixing (Mixing ratio) | ACA200 | 100 | 100 | 100 | 100 | 100 | 100 | 100 | 100 | 200 |
| | Example 1b | 50 | | | | | | | | |
| | Example 2b | | 50 | | | | | | | |
| | Example 3b | | | 50 | | | | | | |
| | Example 4b | | | | 50 | | | | | |
| | Comparative Example 2b | | | | | 50 | | | | |
| | Comparative Example 3b | | | | | | 50 | | | |
| | Comparative Example 4b | | | | | | | 50 | | |
| | DPHA (65%) | | | | | | | | 50 | |
| | Irg 907 | 3 | 3 | 3 | 3 | 3 | 3 | 3 | 3 | 3 |
| | Colorants (0.02%) | 50 | 50 | 50 | 50 | 50 | 50 | 50 | 50 | 50 |
| After drying (80°C x 40 minutes) | Luster | ○ | ○ | ○ | ○ | ○ | ○ | ○ | ○ | ○ |
| | Tackiness | O | ○ | ○ | ○ | X | ○ | X | ○ | ○ |
| After curing | Luster | ○ | ○ | ○ | ○ | ○ | ○ | ○ | ○ | ○ |
| | Tackiness | ○ | ○ | ○ | ○ | X | ○ | Δ | ○ | ○ |
| | Pencil hardness | 4H | 3H | 3H | 3H | 6B↓ | 3H | 2H | 4H | 3H |
| | Solvent resistance | ○ | ○ | ○ | ○ | X | ○ | ○ | ○ | ○ |
| | Flexural resistance | Δ | ○ | ○ | ○ | ○ | X | ○ | Δ | ○ |
| Development (Na₂CO₃ 1%) | Developing time (Two times) | 26S | 18S | 15S | 18S | 15S | 35S | 55S | 28S | 28S |
| | Developing time (Three times) | 32S | 23S | 21S | 25S | 20S | 43S | 59S | 35S | 27S |
| | Sensitivity (Two times) | 5 | 7 | 6 | 6 | 0 | 3 | 2 | 5 | 1 |
| | Sensitivity (Three times) | 6 | 9-1 0 | 9 | 8 | 0 | 5 | 3-4 | 6-7 | 2 |

"Two times" and "three times" in the developing time and the sensitivity mean subjecting to UV irradiation two times and three times, respectively.

### Industrial Applicability

The polyfunctional polyether compound of the present invention, which has (meth) acryloyloxy groups and carboxyl groups at terminals, is excellent in curability with active energy rays and can be applied inmany fields including: various coating fields such as ink, plastics coating, paper printing, film coating, metal coating, and paint application on furniture; lining; an adhesive; and the filed of electronics such as insulating varnish, an insulating sheet, a laminated plate, a printed circuit board, resist ink, and a material for encapsulating semiconductors. In addition, a curable resin composition containing the polyether compound and another curable resin and/or an ethylenic unsaturated compound of the present invention can be used as an image-forming material having alkali developability and high sensitivity for solder resist on a printed circuit board, pigment-dispersed resist, or the like.

## Claims

1. A polyether compound represented by the following formula (4) having two or more polymerizable unsaturated groups and one or more acid groups in a molecule. 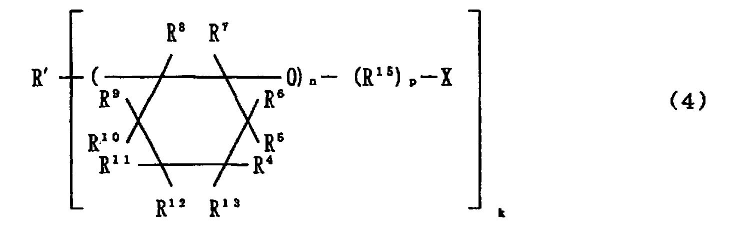 [In the formula (4):
R' is a residue -RHₘ₋ₖ of an organic compound RHₘ containing **m** active hydrogens in a molecule or a group derived from the residue (where **m** is an integer of 1 to 30 and **k** is 1 to **m**);
R⁴ to R¹³ are each a hydrogen atom, a C₁-C₁₀ hydrocarbon group, or a C₁-C₁₀ hydrocarbon group having a polymerizable unsaturated group (where the polymerizable unsaturated group contains -OCO-CR³=CR¹R², R¹ and R² are hydrogen atoms, R³ is a hydrogen atom or a C₁-C₁₀ hydrocarbon group, and another group may be placed between the hydrocarbon group and -OCO-CR³=CR¹R²), and at least one of R⁴ to R¹³ is a C₁-C₁₀ hydrocarbon group having the polymerizable unsaturated group;
R¹⁵ is a residue of a polybasic acid anhydride;
**x** is -COOH, -PO(OH)ₐ(OR)_{b}, or -SO₃R (where R is a hydrogen, a methyl group, or an ethyl group, **a** is 1 or 0, and **a** + **b** = 2);
n is an integer of 1 or more, and a total of n in a molecule is 2 to 50; and
P is an integer of 0 when **x** is -PO(OH)ₐ(OR)_{b} or -SO₃R and 1 or more when **x** is -COOH]

2. A polyether compound according to claim 1, wherein the polymerizable unsaturated group comprises a (meth)acryloyloxy group.

3. A polyether compound according to claim 1, wherein the acid group comprises a carboxyl group.

4. A polyether compound according to claim 1, represented by the following formula (4A) having two or more (meth)acyloyloxy groups and one or more carboxyl groups in a molecule. 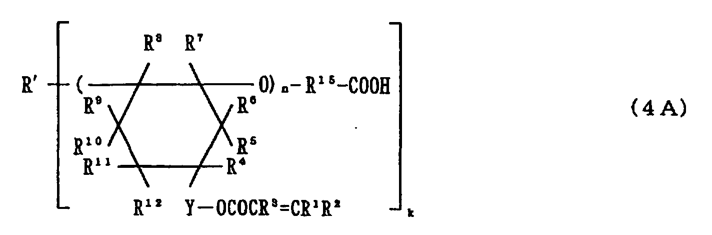 [In the formula (4A):
R' is a residue -RHₘ₋ₖ of an organic compound RHₘ containing **m** pieces of active hydrogen in a molecule or a group derived from the residue (where **m** is an integer of 1 to 30 and **k** is 1 to **m**);
R⁴ to R¹² are each a hydrogen atom or a C₁-C₁₀ hydrocarbon group;
-OCO-CR³=CR¹R² is a (meth)acryloyloxy group,
Y is one of the following structural formulas
-(CH₂)ₙ₁-,
-(CH₂)ₙ₁-(OCO(CH₂)₄)ₙ₂-,
-(CH₂)ₙ₁-(OCO(CH₂)₅)ₙ₂-,
and
-(CH₂)ₙ₁-(OCOCH₂-CH(CH₃)-(CH₂)₂)ₙ₂-
(where **n1** is 1 to 6, hydrogen may be partially substituted with a methyl group, an ethyl group, or a propyl group, and **n2** is 1 to 10);
R¹⁵ is a residue caused by ring-opening of a polybasic acid anhydride; and
**n** is an integer of 1 or more, and a total of **n** in a molecule is 2 to 50]

5. A polyether compound according to any one of claims 1 to 4, wherein the polybasic acid anhydride comprises at least one selected from the group consisting of tetrahydrophthalic anhydride, 4-methyl tetrahydrophthalic anhydride, 3-methyl tetrahydrophthalic anhydride, 3,4,5,6-tetrahydrophthalic anhydride, and hexahydrophthalic anhydride.

6. A polyether compound according to claim 1, represented by the following formula (4A'), wherein the organic compound RHₘ containing **m** pieces of active hydrogens in a molecule is prepared by reacting a polybasic acid anhydride with a compound represented by the following formula (3A) prepared by carrying out a reaction between a compound represented by the following formula (2A) and carboxylic acids, alcohols, phenols, amines, thiols, or silanols (they are represented by R*Hₘ, where **m** is an integer of 1 to 30). 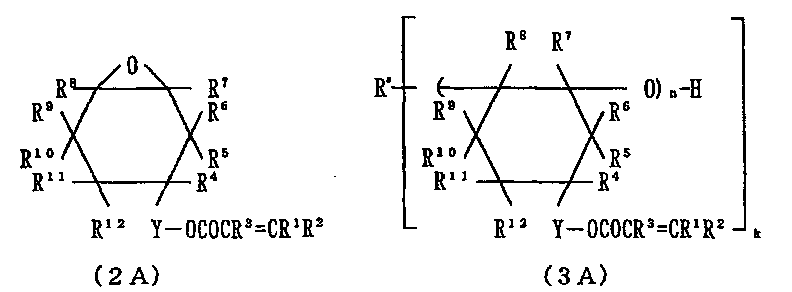 [In the formula (2A):
R¹ and R² are hydrogen atoms, and R³ is a hydrogen atom or a methyl group;
R⁴ to R¹² are each a hydrogen atom, a methyl group, an ethyl group, or a propyl group; and
Y is any one of the following structural formulas
-(CH₂)ₙ₁-,
-(CH₂)ₙ₁-(OCO(CH₂)₄)ₙ₂-,
-(CH₂)ₙ₁-(OCO(CH₂)₅)ₙ₂-,
and
-(CH₂)ₙ₁-(OCOCH₂-CH(CH₃)-(CH₂)₂)ₙ₂-
(where **n1** is 1 to 6, hydrogens may be partially substituted with a methyl group, an ethyl group, or a propyl group, and **n2** is 1 to 10)]
[In the formula (3A):
R'' is a residue -R*Hₘ₋ₖ of carboxylic acids, alcohols, phenols, amines, thiols, or silanols (where **m** is an integer of 1 to 30 and **k** is 1 to **m**);
R¹ to R¹² and Y are the same as those of the formula (2A); and
**n** is an integer of 1 or more and a total of **n** in a molecule is 2 to 50.] 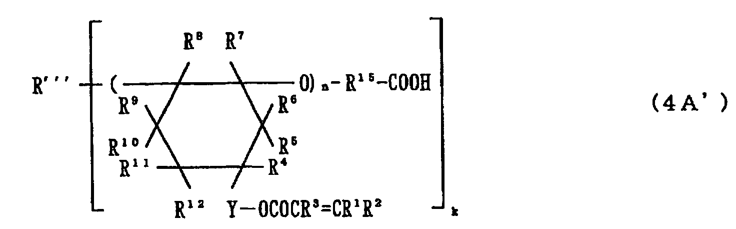
[In the formula (4A'):
R"' is a residue -R*Hₘ₋ₖ or a group derived from a reaction of the residue with a polybasic acid anhydride;
R¹ to R¹², Y, and n are the same as those of the formula (3A); and
R¹⁵ is a residue of a polybasic acid anhydride]

7. A polyether compound according to any one of claims 1 to 6, wherein the organic compound containing **m** pieces of active hydrogen in a molecule comprises trimethylol propane.

8. A polyether compound according to claim 6 or 7, wherein the compound represented by the formula (2A) comprises 3,4-epoxycyclohexylmethyl (meth)acrylate.

9. A polyether compound according to any one of claims 1 to 8, wherein an acid value (solid content-corresponding value) is 5 to 150 KOH mg/g.

10. A curable resin composition **characterized by** comprising the polyether compound according to any one of claims 1 to 9, another curable resin, and/or an ethylenic unsaturated compound.

11. A curable resin composition according to claim 10, wherein the other curable resin comprises a resin obtained by adding a (meth)acrylic acid/(meth)acrylate copolymer with the compound represented by the formula (2A) described in claim 6.

12. A cured article obtained by curing the curable resin composition according to claim 10 or 11.

13. A process for producing a polyether compound represented by the formula (4) described in claim 1, comprising the steps of:
reacting an organic compound RHₘ containing **m** pieces of active hydrogens in a molecule (where **m** is 1 to 30) with a compound represented by the following formula (2) to obtain a compound represented by the following formula (3): 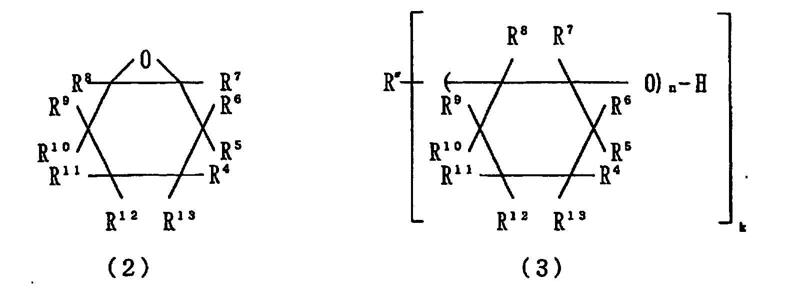
[In the formula (2):
R⁴ to R¹³ are each a hydrogen atom, a C₁-C₁₀ hydrocarbon group, or a C₁-C₁₀ hydrocarbon group having a polymerizable unsaturated group (where the polymerizable unsaturated group contains -OCO-CR³=CR¹R², R¹ and R² are hydrogen atoms, R³ is a hydrogen atom or a C₁-C₁₀ hydrocarbon group, and another group may be placed between the hydrocarbon group and -OCO-CR³=CR¹R²), and at least one of R⁴ to R¹³ is a C₁-C₁₀ hydrocarbon group having the polymerizable unsaturated groups.]
[In the formula (3):
R" is a residue -RHₘ₋ₖ of an organic compound containing **m** pieces of active hydrogens in a molecule (where **m** is an integer of 1 to 30 and **k** is 1 to **m**);
R⁴ to R¹³ are the same as those of the formula (2); and
**n** is an integer number of 1 or more and a total of **n** in a molecule is 2 to 50]; and
reacting the compound represented by the formula (3) obtained as described above with any one of polybasic acid anhydride, phosphoric acid, ethyl phosphate, diethyl phosphate, monoalkyl ester or dialkyl ester of glucose phosphate, sulfuric acid, methyl sulfate, and ethyl sulfate.

14. A process for producing a polyether compound according to claim 13, wherein a chemical equivalent ratio (the compound represented by the formula (3)/polybasic acid anhydride) is 1 to 30.

15. A process for producing a polyether compound according to claim 13 or 14, further comprising ventilation of a reaction system with a gas mixture containing oxygen.

16. An image-forming material comprising the polyether compound represented by the formula (4) described in claim 1, other curable resin, and/or an ethylenic unsaturated compound as essential ingredients.

17. An image-forming material according to claim 16, wherein the other curable resin comprises a resin obtained by adding a (meth)acrylic acid/(meth)acrylate copolymer with the compound represented by the formula (2A) described in claim 6.
